# EUROPEAN PATENT SPECIFICATION

(11) **EP 3 784 014 B1**
(45) Date of publication and mention of the grant of the patent: **22.07.2026**
(21) Application number: 18915545.0
(22) Date of filing: 17.04.2018
(51) Int. Cl.: H05K 13/04, H05K 13/08

(54) **MOUNTING OPERATION MACHINE AND CONFIRMATION METHOD**
MONTAGEOPERATIONSMASCHINE UND BESTÄTIGUNGSVERFAHREN
MACHINE D'OPÉRATION DE MONTAGE ET PROCÉDÉ DE CONFIRMATION

(43) Date of publication of application: 24.02.2021
(73) Proprietor: Fuji Corporation, Chiryu-shi, Aichi 472-8686 (JP)
(72) Inventor: NARITA, Junichi, Chiryu-shi, Aichi 472-8686 (JP); TESHIMA, Chikashi, Chiryu-shi, Aichi 472-8686 (JP)
(74) Representative: Grünecker Patent- und Rechtsanwälte PartG mbB
(86) International application number: PCT/JP2018/015847
(87) International publication number: WO 2019/202655

(56) References cited:
- JP-A- 2005 303 179
- JP-A- 2005 303 179
- JP-A- 2006 114 534
- JP-A- 2013 115 142
- JP-A- 2014 067 860
- JP-A- 2016 134 531
- JP-A- 2016 134 531
- JP-A- 2017 130 549

## Description

### Technical Field

The present invention relates to a mounting work machine or the like capable of confirming the slidability of a nozzle tube of a suction nozzle.

### Background Art

In a mounting work machine, it is desired to inspect a suction nozzle in order to ensure a suitable mounting work. In the following Patent Literature, a technique related to inspection of a suction nozzle is described. Patent Literature 3 discloses all features of the preambles of appended independent claims 1 and 4.

### Patent Literature

Patent Literature 1: WO 2015/162700 A1
Patent Literature 2: JP 2006 108384 A
Patent Literature 3: JP 2016 134531 A

### Summary of the Invention

### Technical Problem

According to the technique described in the above-described Patent Literatures, it is possible to appropriately perform the inspection of the suction nozzle to some extent; however, it is desired to more appropriately perform the inspection of the suction nozzle. In view of such circumstances, an object of the present invention is to more appropriately perform inspection of a suction nozzle.

### Solution to Problem

In order to solve the above-described problem, the invention provides a work machine as defined by appended independent claim 1.

In order to solve the above-described problem, the invention further provides a method as defined by appended independent method claim 4.

### Advantageous Effect of the Invention

In the present disclosure, the slidability of the nozzle tube is confirmed based on changes in the torque value of the electromagnetic motor immediately after the tip end of the nozzle tube of the suction nozzle is pressed against a predetermined set part. Accordingly, it is possible to appropriately confirm the slidability of the nozzle tube and inspect the suction nozzle.

### Brief Description of Drawings

Fig. 1 is a perspective view illustrating a component mounting machine.
Fig. 2 is a perspective view illustrating a component mounting device of the component mounting machine.
Fig. 3 is a perspective view illustrating a working head.
Fig. 4 is a schematic sectional view illustrating a mounting unit.
Fig. 5 is a perspective view illustrating a suction nozzle.
Fig. 6 is a schematic sectional view illustrating the mounting unit.
Fig. 7 is a schematic sectional view illustrating the mounting unit.
Fig. 8 is a block diagram illustrating a control device.
Fig. 9 is a view illustrating a relationship between a position of the mounting unit in an up-down direction and a torque value of an electromagnetic motor.

### Description of Embodiments

Hereinafter, as exemplary embodiments of the present invention, examples of the present invention will be described in detail with reference to the drawings.

### (A) Configuration of Component Mounting Machine

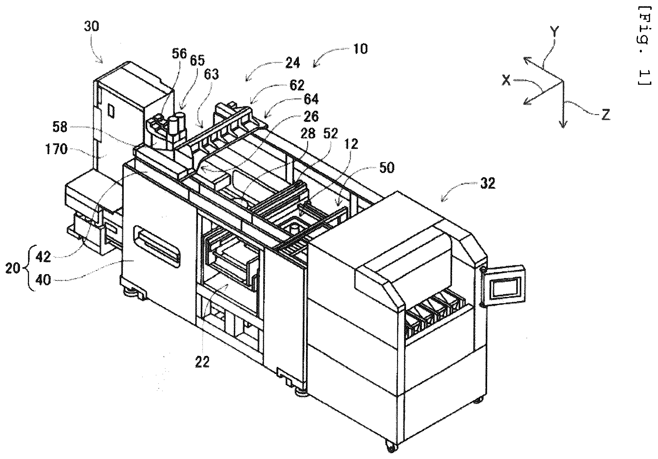

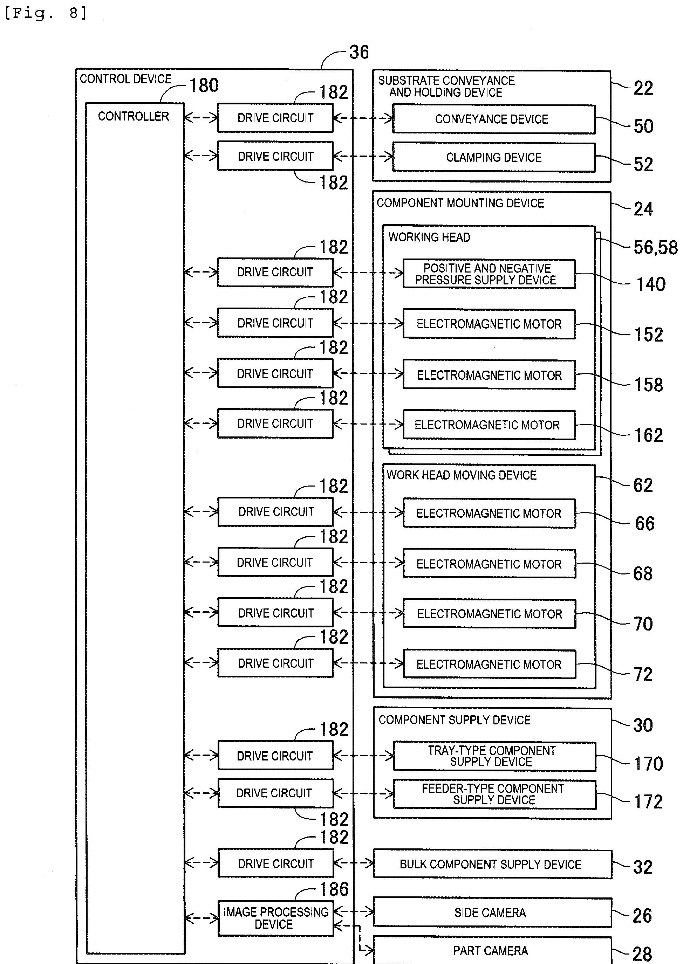

Fig. 1 illustrates component mounting machine 10. Component mounting machine 10 is a device for executing mounting work of components on circuit substrate 12. Component mounting machine 10 includes device main body 20, substrate conveyance and holding device 22, component mounting device 24, side camera 26, part camera 28, nozzle station 29, component supply device 30, bulk component supply device 32, and control device (refer to Fig. 8) 36. Further, a circuit board, a substrate having a three-dimensional structure, or the like can be used as circuit substrate 12, and a printed wiring board, a printed circuit board, or the like can be used as a circuit board.

Device main body 20 includes frame section 40 and beam section 42 overlaid on frame section 40. Substrate conveyance and holding device 22 is disposed at the center of frame section 40 in the front-rear direction, and has conveyance device 50 and clamping device 52. Conveyance device 50 is a device for conveying circuit substrate 12, and clamping device 52 is a device for holding circuit substrate 12. Accordingly, substrate conveyance and holding device 22 conveys circuit substrate 12 and fixedly holds circuit substrate 12 at a predetermined position. **In** the following description, the conveyance direction of circuit substrate 12 is referred to as the X direction, the horizontal direction perpendicular to the direction is referred to as the Y direction, and the vertical direction is referred to as the Z direction. In other words, the width direction of component mounting machine 10 is the X direction, and the front-rear direction is the Y direction.

Component mounting device 24 is disposed on beam section 42 and includes two working heads 56 and 58 and working head moving device 62. Working head moving device 62 includes X-direction moving device 63, Y-direction moving device 64, and Z-direction moving device 65. X-direction moving device 63 and Y-direction moving device 64 include electromagnetic motors (refer to Fig. 8) 66 and 68, respectively, and by the operation of each of electromagnetic motors 66 and 68, two working heads 56 and 58 integrally move to any position on frame section 40. Z-direction moving device 65 includes electromagnetic motors (refer to Fig. 8) 70 and 72, and by the operation of each of electromagnetic motors 70 and 72, sliders 74 and 76 individually move in the up-down direction. Working heads 56 and 58 are detachably mounted to sliders 74 and 76. Accordingly, working heads 56 and 58 individually move in the up-down direction by Z-direction moving device 65.

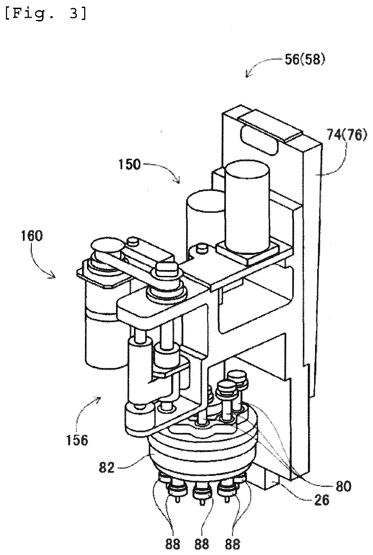

Further, each of working heads 56 and 58 mount components on circuit substrate 12. As illustrated in Fig. 3, working heads 56 and 58 include eight rod-shaped mounting units 80. These eight mounting units 80 are held in a state where the axial direction is perpendicular at an equal angular pitch at the outer circumferential portion of unit holding body 82, and suction nozzle 88 is mounted at the tip portion of each of mounting units 80. Then, suction nozzle 88 mounted at the tip portion mounting unit 80 extends downward from the lower surface of unit holding body 82. In addition, in Fig. 3, working heads 56 and 58 in a state where the cover is removed are illustrated.

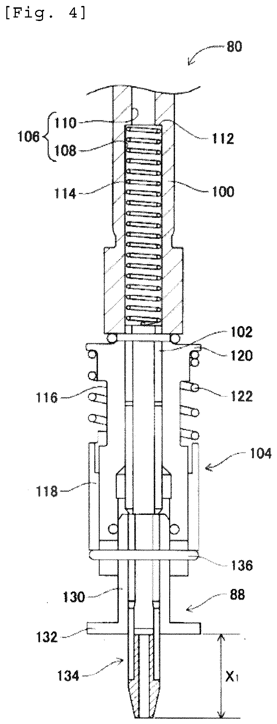

Further, as illustrated in Fig. 4, each mounting unit 80 generally includes tubular unit main body 100, coupling pipe 102 that extends downward from the lower end of unit main body 100, and holder 104 that holds coupling pipe 102 therein. Inside unit main body 100, through hole 106 that penetrates in the up-down direction is formed, through hole 106 is divided by large-diameter section 108 positioned below, and small-diameter section 110 continuous upward from large-diameter section 108, and step surface 112 is formed between large-diameter section 108 and small-diameter section 110.

Then, the inner diameter of large-diameter section 108 of through hole 106 is slightly greater than the outer diameter of coupling pipe 102, and the upper end portion of coupling pipe 102 is inserted into large-diameter section 108 of through hole 106. Further, between step surface 112 of through hole 106 and the upper end face of coupling pipe 102, coil spring 114 is disposed in a state of being compressed. Accordingly, coupling pipe 102 is biased toward the direction extending from large-diameter section 108 of through hole 106.

Holder 104 includes inner tube 116 and outer tube 118. The lower end portion of unit main body 100 is fixed to the upper end portion of inner tube 116, and the upper end portion of outer tube 118 is externally fitted to the lower end portion of inner tube 116. Further, the inside of holder 104, that is, the inside of inner tube 116 and outer tube 118, coupling pipe 102 that extends from large-diameter section 108 of unit main body 100 is held. Accordingly, in a state where coupling pipe 102 is held on the inside, holder 104 can extend and contract. In addition, flange section 120 that protrudes outward is formed at the upper end portion of inner tube 116, and coil spring 122 is disposed in a compressed state between flange section 120 and the upper end portion of outer tube 118. Accordingly, outer tube 118 of holder 104 for holding coupling pipe 102 is biased downward.

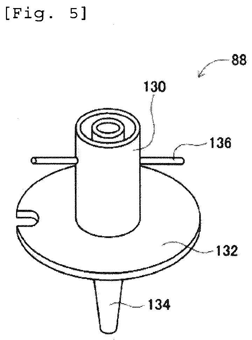

Further, on the lower end portion of holder 104, that is, the lower end portion of outer tube 118, suction nozzle 88 is mounted. Then, coupling pipe 102 held inside holder 104 makes the inside of suction nozzle 88 and through hole 106 of unit main body 100 communicate with each other, and accordingly, suction nozzle 88 picks up and holds electronic components by suctioning air from through hole 106. Specifically, as illustrated in Fig. 5, suction nozzle 88 includes body cylinder 130, flange section 132, suction pipe 134, and locking pin 136. Body cylinder 130 has a cylindrical shape, and flange section 132 protrudes outward from the lower end portion of body cylinder 130. Suction pipe 134 has a thin pipe shape and is held by body cylinder 130 to be slidable in the axial line direction in a state of extending downwards from the lower end portion of body cylinder 130. Locking pin 136 is provided at the upper end portion of body cylinder 130 so as to extend in the radial direction of body cylinder 130, and suction nozzle 88 is detachably attached to the lower end portion of holder 104, that is, the lower end portion of outer tube 118, using locking pin 136.

In addition, as illustrated in Fig. 4, the lower end face of coupling pipe 102 held by holder 104 is in contact with the upper end face of suction pipe 134 slidably held by body cylinder 130. Coupling pipe 102 is biased downward by coil spring 114 disposed in through hole 106 of unit main body 100. Therefore, suction pipe 134 is biased in a direction extending downward from the lower end portion of body cylinder 130.

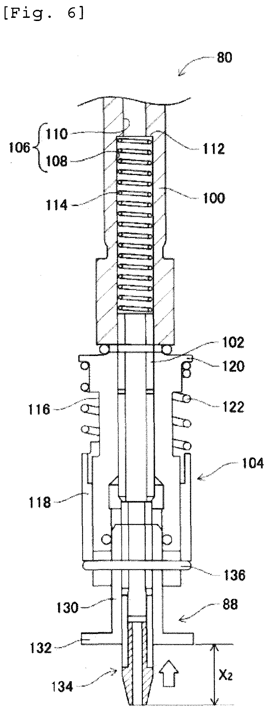

However, the extension amount of suction pipe 134 from the lower end portion of body cylinder 130 is regulated to X1 by a stopper (not illustrated). In other words, in a state where suction pipe 134 has extension amount X1, the tip end of suction pipe 134 is positioned at the lowest position, the extension amount of suction pipe 134 decreases, and accordingly, suction pipe 134 slides toward the inside of body cylinder 130, and suction nozzle 88 contracts. At this time, as illustrated in Fig. 6, with the sliding of suction pipe 134 to the inside of body cylinder 130, coupling pipe 102 is also driven and enters the inside of through hole 106 of unit main body 100, and accordingly, the coupling of through hole 106 and suction nozzle 88 is maintained by coupling pipe 102. Then, through hole 106 of unit main body 100 communicates with positive and negative pressure supply device (refer to Fig. 8) 140 through a positive pressure air passage and a negative pressure air passage. Accordingly, as illustrated in FIG. 4, in a state where suction pipe 134 has extension amount X1 and suction nozzle 88 extends the most, as the negative pressure air is supplied to through hole 106, suction nozzle 88 picks up and holds the electronic component. Meanwhile, as illustrated in Fig. 6, even in a state where suction pipe 134 has extension amount X2 (< X1) and suction nozzle 88 contracts, as the negative pressure air is supplied to through hole 106, suction nozzle 88 picks up and holds the electronic component. Further, in a state where suction nozzle 88 extends and contracts, as the positive pressure air is supplied to through hole 106, the held electronic component is disengaged.

Further, as illustrated in Fig. 3, unit holding body 82 that holds eight mounting units 80 intermittently rotates for each installation angle of mounting unit 80 by electromagnetic motor (refer to Fig. 8) 152 of holding body rotating device 150. Accordingly, mounting unit 80 is sequentially stopped at the lifting and lowering station which is one stopping position among the stopping positions of multiple mounting units 80. Mounting unit 80 positioned at the lifting and lowering station is lifted and lowered by electromagnetic motor (refer to Fig. 8) 158 of unit lifting and lowering device 156. Accordingly, the position in the up-down direction of the component picked up and held by suction nozzle 88 is changed. Further, a stopping position different from the lifting and lowering station is a revolving station, mounting unit 80 positioned at the station rotates by electromagnetic motor (refer to Fig. 8) 162 of revolving device 160. Accordingly, the holding orientation of the component picked up and held by suction nozzle 88 is changed.

Further, side camera 26 is attached to the lower end of sliders 74 and 76 in a state of facing the side, and the tip end of one mounting unit 80 among multiple mounting units 80 of working heads 56 and 58 mounted on sliders 74 and 76, that is, suction nozzle 88, is imaged. Accordingly, side camera 26 images the components held by suction nozzle 88 of working heads 56 and 58 from the side. As illustrated in Fig. 1, part camera 28 is disposed between substrate conveyance and holding device 22 and component supply device 30 on frame section 40 in a state of facing upward. Accordingly, part camera 28 images the components held by suction nozzle 88 of working heads 56 and 58 from the below.

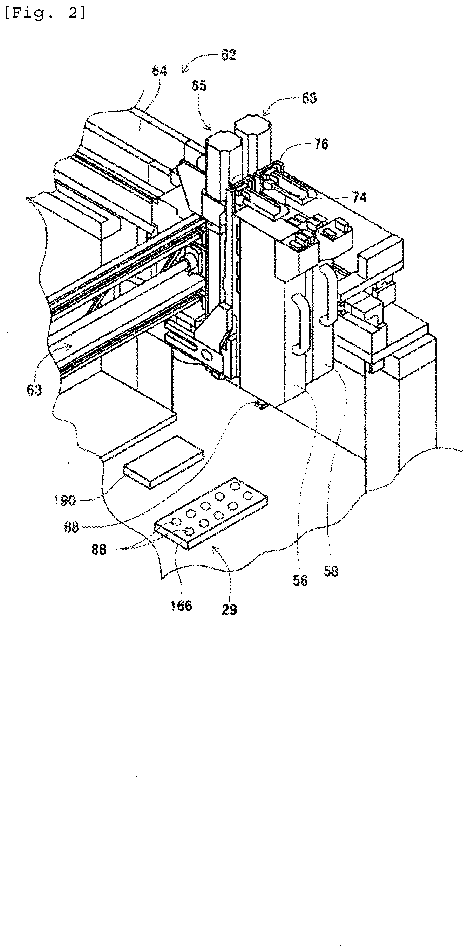

In addition, as illustrated in Fig. 2, nozzle station 29 includes nozzle tray 166 that accommodates multiple suction nozzles 88. **In** nozzle station 29, suction nozzle 88 attached to mounting unit 80 of working heads 56 and 58 and suction nozzle 88 accommodated in nozzle tray 166 are automatically exchanged, if necessary.

Further, as illustrated in Fig. 1, component supply device 30 is disposed at one end portion of frame section 40 in the front-rear direction. Component supply device 30 includes tray-type component supply device 170 and feeder-type component supply device (refer to Fig. 8) 172. Tray-type component supply device 170 is a device for supplying components which is in a state of being placed on a tray. Feeder-type component supply device 172 is a device for supplying components by a tape feeder or a stick feeder (not illustrated).

Bulk component supply device 32 is disposed at the other end portion of frame section 40 in the front-rear direction. Bulk component supply device 32 is a device for aligning scattered multiple components and supplying the components in an aligned state. **In** other words, bulk component supply device 32 is a device for aligning multiple components in any orientation to a predetermined orientation, and supplying the components in a predetermined orientation.

As illustrated in Fig. 8, control device 36 includes controller 180, multiple drive circuits 182, and image processing device 186. Multiple drive circuits 182 are connected to conveyance device 50, clamping device 52, electromagnetic motors 66, 68, 70, 72, 152, 158, and 162, positive and negative pressure supply device 140, tray-type component supply device 170, feeder-type component supply device 172, and bulk component supply device 32 which are described above. Controller 180 includes a CPU, a ROM, a RAM, and the like, is mainly a computer, and is connected to multiple drive circuits 182. Accordingly, the operations of substrate conveyance and holding device 22, component mounting device 24, and the like are controlled by controller 180. Controller 180 is also connected to image processing device 186. Image processing device 186 is for processing image data obtained by side camera 26 and part camera 28, and controller 180 acquires various types of information from the image data.

### (B) Operation of Component Mounting Machine

In component mounting machine 10, with the above-described configuration, the component mounting work is performed on circuit substrate 12 held by substrate conveyance and holding device 22. Specifically, circuit substrate 12 is conveyed to a work position and held at that position in a fixed manner by clamping device 52. Further, component supply device 30 or bulk component supply device 32 supplies electronic components at a predetermined supply position. Then, any one of working heads 56 and 58 is moved above the supply position of the component, mounting unit 80 positioned at the lifting and lowering station of working heads 56 and 58 is lowered, and accordingly, the electronic component is picked up and held by suction nozzle 88 of mounting unit 80.

Next, working heads 56 and 58 move above part camera 28, and the electronic component held by suction nozzle 88 is imaged by part camera 28. Further, in working heads 56 and 58 that hold the electronic component, the electronic component held by suction nozzle 88 is imaged by side camera 26. Then, based on the captured image data of side camera 26 and part camera 28, controller 180 calculates the holding orientation or the like of the electronic component held by suction nozzle 88. Subsequently, working heads 56 and 58 that hold the electronic components move above circuit substrate 12 and mount the components which are being held on circuit substrate 12 after correcting errors or the like in the holding orientation of the components.

Further, in component mounting machine 10, as illustrated in Fig. 2, jig base 190 is disposed between substrate conveyance and holding device 22 and bulk component supply device 32. This may be between substrate conveyance and holding device 22 and component supply device 30. Jig base 190 is a base for temporarily mounting the electronic components, and simulation of mounting work of the electronic components is performed with respect to jig base 190. Accordingly, the mounting work of the appropriate electronic components to circuit substrate 12 is ensured.

### (C) Inspection of Suction Nozzle

Further, component mounting machine 10 has a structure in which the load on the electronic component at the time of mounting work is reduced and suction nozzle 88 can extend and contract. Specifically, as illustrated in Fig. 4, in a state where suction nozzle 88 extends the most, suction pipe 134 has extension amount X1, and suction pipe 134 is biased downward together with coupling pipe 102 due to elastic force of coil spring 114. Then, for example, when the electronic component is picked up and held by suction nozzle 88, and when the electronic component is in contact with the tip end of suction pipe 134, as illustrated in Fig. 6, suction pipe 134 slides to the inside of body cylinder 130 against the elastic force of coil spring 114. Accordingly, the load on the electronic component when the electronic component is held by suction nozzle 88 is reduced. Further, even when the electronic component held by suction nozzle 88 is mounted on circuit substrate 12, when the electronic component held by suction nozzle 88 is in contact with circuit substrate 12, suction pipe 134 that holds the electronic component slides to the inside of body cylinder 130 against the elastic force of coil spring 114. Accordingly, the load on the electronic component when the electronic component is mounted on circuit substrate 12 is reduced.

In this manner, as suction nozzle 88 has a structure that can extend and contract, the load on the electronic component during the mounting work is reduced. However, there is a case where the slidability of suction pipe 134 deteriorates due to degradation, adhesion of dirt, or the like. In such a case, for example, even when the electronic component comes into contact with the tip end of suction pipe 134, suction pipe 134 is unlikely to slide toward the inside of body cylinder 130, and there is a concern that the load on the electronic component increases. Therefore, in mounting unit 80, when the slidability of suction pipe 134 deteriorates, holder 104 that holds suction nozzle 88 contracts, and the load on the electronic component is reduced.

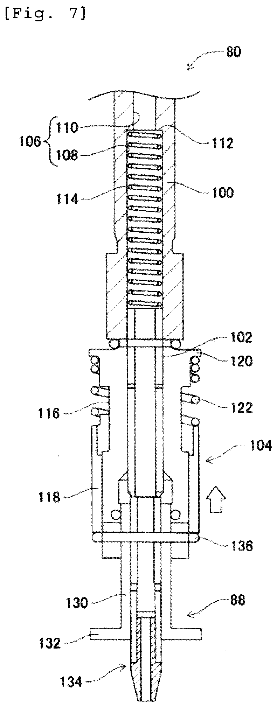

More specifically, for example, in a state where the slidability of suction pipe 134 remarkably deteriorates and suction pipe 134 and body cylinder 130 are fixed, when the electronic component comes into contact with the tip end of suction pipe 134, suction pipe 134 does not slide toward the inside of body cylinder 130. However, as illustrated in Fig. 7, outer tube 118, which is fixedly coupled to body cylinder 130 of suction nozzle 88, against the elastic force of coil spring 122, moves upward, and holder 104 contracts. At this time, since coupling pipe 102 is also pushed upward together with outer tube 118, against the elastic force of coil spring 114, coupling pipe 102 moves upward. Accordingly, even in a state where suction pipe 134 and body cylinder 130 are fixed and suction nozzle 88 does not contract, the load on the electronic component is reduced.

In this manner, in mounting unit 80, even in a state where the slidability of suction pipe 134 deteriorates, it is possible to reduce the load on the electronic component. However, in a state where the slidability of suction pipe 134 deteriorates, it is not preferable to continuously execute the mounting work, and it is desirable to detect the deterioration of the slidability of suction pipe 134 as early as possible. Therefore, in component mounting machine 10, at an interval between the mounting works, the tip end of suction nozzle 88, that is, the tip end of suction pipe 134 is pressed against jig base 190, and based on the torque value of the motor at this time, the slidability of suction pipe 134 is confirmed.

Specifically, for example, when circuit substrate 12, which is at an interval between the mounting works, is conveyed to the work position and held fixedly by clamping device 52, working heads 56 and 58 are moved above jig base 190, and mounting unit 80 is lowered toward jig base 190. Incidentally, naturally, suction nozzle 88 is mounted on mounting unit 80, and suction nozzle 88 is in a state of not holding anything. At this time, the driving source for lowering mounting unit 80, that is, the operation of electromagnetic motor 158 of unit lifting and lowering device 156 is controlled, but when mounting unit 80 is lowered, the operation of electromagnetic motor 158 is controlled such that the tip end of suction nozzle 88, that is, the tip end of suction pipe 134, comes into contact with the surface of jig base 190 and is slightly pressed. In other words, the operation of electromagnetic motor 158 is controlled such that the tip end of suction pipe 134 is positioned slightly below the Z-axis coordinate of the surface of jig base 190, specifically, for example, a few mm below.

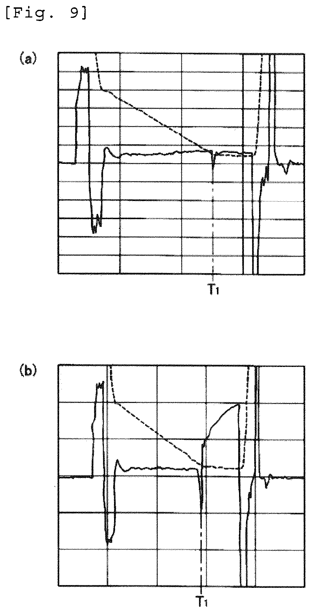

In this manner, when the operation of electromagnetic motor 158 is controlled, and when there is no problem in the slidability of suction pipe 134, that is, when there is no abnormality in suction nozzle 88, suction pipe 134 slides against the elastic force of coil spring 114. At this time, since the elastic force of coil spring 114 is relatively small, the torque value of electromagnetic motor 158 hardly increases. Specifically, when describing with reference to the table of Fig. 9(a) illustrating the position (dotted line) of mounting unit 80 in the up-down direction and the torque value (solid line) of electromagnetic motor 158, the position (dotted line) of mounting unit 80 in the up-down direction is lowered with the operation of electromagnetic motor 158. At this time, the torque value (solid line) of electromagnetic motor 158 hardly changes. Then, at the timing (T1) at which the tip end of suction pipe 134 comes into contact with the surface of jig base 190, a load is applied to electromagnetic motor 158, and the torque value of electromagnetic motor 158 changes for a moment.

**In** addition, mounting unit 80 stops being lowered and is maintained at this position. At this time, in mounting unit 80, as illustrated in Fig. 6, suction nozzle 88 contracts, and suction pipe 134 is maintained in a state of sliding toward the inside of body cylinder 130 against the elastic force of coil spring 114. Therefore, electromagnetic motor 158 exerts a motor force against the elastic force of coil spring 114; however, since the elastic force of coil spring 114 is small, the torque value of electromagnetic motor 158 hardly changes.

Meanwhile, when there is a problem in the slidability of suction pipe 134 and there is an abnormality in suction nozzle 88, the description will be given using the table of Fig. 9(b) illustrating the position (dotted line) of mounting unit 80 in the up-down direction and the torque value (dotted line) of electromagnetic motor 158. First, the position (dotted line) of mounting unit 80 in the up-down direction is lowered with the operation of electromagnetic motor 158. At this time, the torque value (solid line) of electromagnetic motor 158 hardly changes. Then, at the timing (T1) at which the tip end of suction pipe 134 comes into contact with the surface of jig base 190, a load is applied to electromagnetic motor 158, and the torque value of electromagnetic motor 158 changes for a moment.

In addition, mounting unit 80 stops being lowered and is maintained at this position. At this time, in mounting unit 80, as illustrated in Fig. 7, holder 104 contracts, and outer tube 118 is maintained in a state of being moved upward against the elastic force of coil spring 122. Furthermore, coupling pipe 102 also moves upward together with outer tube 118 and is maintained in a state of being moved upward against the elastic force of coil spring 114. Therefore, electromagnetic motor 158 exerts a motor force that is against not only the elastic force of coil spring 114 but also the elastic force of coil spring 122, and the torque value of electromagnetic motor 158 greatly changes.

**In** this manner, when the slidability of suction pipe 134 is excellent, the torque value of the electromagnetic motor 158 when lowering mounting unit 80 hardly changes after suction pipe 134 comes into contact with jig base 190. Meanwhile, when the slidability of suction pipe 134 is poor, the torque value of electromagnetic motor 158 when lowering mounting unit 80 greatly changes after suction pipe 134 comes into contact with jig base 190. Therefore, when the torque value of electromagnetic motor 158 after a predetermined period of time, for example, several msec has elapsed from the timing (T1) at which the tip end of suction pipe 134 comes into contact with the surface of jig base 190 exceeds the threshold value, it is determined that the slidability of suction pipe 134 is poor. Incidentally, in electromagnetic motor 158, since the position control is performed according to the detected value of the encoder, the timing (T1) at which the tip end of suction pipe 134 comes into contact with the surface of jig base 190 is detected according to the detected value of the encoder.

In this manner, in component mounting machine 10, the slidability of suction pipe 134 of suction nozzle 88 is confirmed by using the existing equipment. In other words, jig base 190 and unit lifting and lowering device 156 are existing equipment, and the slidability of suction pipe 134 of suction nozzle 88 can be confirmed only by controlling the operation of unit lifting and lowering device 156 such that the tip end of suction nozzle 88 comes into contact with the surface of jig base 190, and by monitoring the torque value of electromagnetic motor 158 at this time.

Further, since the slidability of suction pipe 134 of suction nozzle 88 can be confirmed only by lifting and lowering mounting unit 80, it is possible to perform the inspection of suction nozzle 88 by using a short period of time such as an interval between the mounting works. In other words, since suction nozzles 88 mounted on all mounting units 80 of working heads 56 and 58 can be individually inspected, it is possible to individually manage each of multiple suction nozzles 88.

Before the slidability of suction pipe 134 remarkably deteriorates, for example, suction pipe 134 slides; however, even when the sliding resistance rises, the torque value of electromagnetic motor 158 rises with the rise of the sliding resistance of suction pipe 134. Therefore, by optimizing the threshold value which is a reference for determining the torque value of electromagnetic motor 158, it is also possible to detect the abnormality of suction nozzle 88 in the initial stage.

However, when the slidability of suction pipe 134 is inspected by the above-described method, there is a case where the deterioration of the slidability of suction pipe 134 is not confirmed. Specifically, for example, when the tip end of suction pipe 134 is pressed against jig base 190, when suction pipe 134 slides toward the inside of body cylinder 130, as described above, the torque value of electromagnetic motor 158 hardly changes, and it is determined that suction nozzle 88 is normal. However, as suction pipe 134 is pressed against jig base 190, suction pipe 134 slides toward the inside of body cylinder 130, and in this state, that is, in a state where suction pipe 134 enters the inside of body cylinder 130, there is a case where body cylinder 130 and suction pipe 134 are fixed.

**In** other words, for example, in a state where suction nozzle 88 extends the most and suction pipe 134 slightly enters the inside of body cylinder 130, suction pipe 134 slides smoothly; however, a foreign matter enters the back of body cylinder 130, and suction pipe 134 enters the inside of body cylinder 130 by a predetermined amount, and accordingly, there is a case where the foreign matter comes into contact with suction pipe 134. When the foreign matter enters between body cylinder 130 and suction pipe 134, in a state where suction pipe 134 enters the inside of body cylinder 130 by a predetermined amount, there is a case where body cylinder 130 and suction pipe 134 are fixed. In other words, as illustrated in Fig. 6, in a state where suction nozzle 88 contracts, when there is no problem in the slidability of suction pipe 134, suction nozzle 88 extends by the elastic amount of coil spring 114; however, there is a case where suction nozzle 88 does not extend due to the foreign matter that entered between body cylinder 130 and suction pipe 134. In such a case, there is no problem in the slidability of suction pipe 134 when suction nozzle 88 contracts, and accordingly, the deterioration of the slidability of suction pipe 134 cannot be confirmed by the inspection by the above-described method.

In view of this, the slidability of suction pipe 134 is confirmed based on the tip end position of suction pipe 134 before suction pipe 134 is pressed against jig base 190 and the tip end position of suction pipe 134 after suction pipe 134 is pressed against jig base 190. Specifically, before suction pipe 134 is pressed against jig base 190, suction nozzle 88 is imaged by side camera 26. Then, the extension amount of suction pipe 134 from body cylinder 130, that is, the extension amount of suction pipe 134 before the pressing work is calculated based on the captured image data.

Subsequently, mounting unit 80 is lowered, and the tip end of suction pipe 134 is pressed against the surface of jig base 190. In other words, the slidability of suction pipe 134 is confirmed by the above-described method. At this time, the torque value of electromagnetic motor 158 is monitored, and it is determined whether the torque value of electromagnetic motor 158 after a predetermined period of time has elapsed from the timing (T1) at which the tip end of suction pipe 134 comes into contact with the surface of jig base 190 exceeds the threshold value. Then, when the monitoring of the torque value of electromagnetic motor 158 is completed, mounting unit 80 is raised, and suction nozzle 88 in which the pressing of suction pipe 134 to jig base 190 is completed is imaged by side camera 26. Then, the extension amount of suction pipe 134 from body cylinder 130, that is, the extension amount of suction pipe 134 after the pressing work is calculated based on the captured image data.

In this manner, when the extension amount of suction pipe 134 before the pressing work and the extension amount of suction pipe 134 after the pressing work are calculated, it is determined whether the difference between the extension amount of suction pipe 134 before the pressing work and the extension amount of suction pipe 134 after the pressing work is equal to or less than the set amount. **In** addition, when the difference between the extension amount of suction pipe 134 before the pressing work and the extension amount of suction pipe 134 after the pressing work exceeds the set amount, it is determined that the slidability of suction pipe 134 deteriorates. **In** other words, by pressing suction pipe 134 against jig base 190, suction pipe 134 that entered the inside of body cylinder 130 is in a state of remaining inside body cylinder 130, and it is determined that an abnormality occurred in suction nozzle 88. Meanwhile, when the difference between the extension amount of suction pipe 134 before the pressing work and the extension amount of suction pipe 134 after the pressing work is equal to or less than the set amount, it is determined that the slidability of suction pipe 134 is excellent. In other words, by pressing suction pipe 134 against jig base 190, suction pipe 134 that entered the inside of body cylinder 130 is restored by the elastic force of coil spring 114, and it is determined that suction nozzle 88 is normal.

In this manner, by comparing the tip end positions of suction pipe 134 before and after the pressing work of suction pipe 134 against jig base 190, it is possible to more reliably confirm the slidability of suction pipe 134. In addition, even when comparing the tip end positions of suction pipe 134, the slidability of suction pipe 134 can be confirmed by using existing equipment such as side camera 26. Further, similarly to the confirmation of the slidability of suction pipe 134 using the torque value of electromagnetic motor 158, it is possible to perform the confirmation work in a short period of time, individual management of each of multiple suction nozzles 88, and the like.

In addition, in any of the confirmation work of the slidability of suction pipe 134 using the torque value of electromagnetic motor 158 and the confirmation work of the slidability of suction pipe 134 by comparing the tip end positions of suction pipe 134, when it is determined that the slidability of suction pipe 134 deteriorates, the exchange work of suction nozzle 88 is executed. In other words, in nozzle station 29, suction nozzle 88 determined that the slidability of suction pipe 134 deteriorates is removed from mounting unit 80, and is accommodated in nozzle tray 166, and suction nozzle 88 accommodated in nozzle tray 166 is mounted in mounting unit 80. Accordingly, while reducing the load on the electronic components, appropriate mounting work is ensured. When there is no suction nozzle 88 that can be exchanged, it is notified that suction nozzle 88 should be replenished or exchanged.

Incidentally, component mounting machine 10 is an example of a mounting work machine. Side camera 26 is an example of an imaging device. Control device 36 is an example of a confirmation device. Suction nozzle 88 is an example of a suction nozzle. Suction pipe 134 is an example of a nozzle tube. Unit lifting and lowering device 156 is an example of a lifting and lowering device. Electromagnetic motor 158 is an example of an electromagnetic motor. Jig base 190 is an example of a set part.

In addition, the present invention is not limited to the above-described examples, and can be implemented in various aspects with various changes as long as the changes are within the scope of the appended claims. Specifically, for example, in the above-described example, when the slidability of suction pipe 134 is confirmed, suction pipe 134 is pressed against jig base 190; however, suction pipe 134 may be pressed against any location as long as a predetermined hardness is provided and the positional coordinates can be specified.

### Reference Signs List

10: component mounting machine (mounting work machine), 26: side camera (imaging device), 36: control device (confirmation device), 88: suction nozzle, 134: suction pipe (nozzle tube), 156: unit lifting and lowering device (lifting and lowering device), 158: electromagnetic motor, 190: jig base

## Claims

1. A mounting work machine (10) comprising:
a suction nozzle (88) wherein a nozzle tube (134) is slidably held by a body cylinder (130), the suction nozzle (88) being configured to extend and contract with sliding of the nozzle tube (134) and a first coil spring (114) biasing the nozzle tube (134) downwards;
a lifting and lowering device (156) configured to lift and lower the suction nozzle (88) by an operation of an electromagnetic motor (158); and
a confirmation device (36) configured to confirm slidability of the nozzle tube (134) relative to the body cylinder (130) by monitoring a torque value of the electromagnetic motor (158) when a tip end of the nozzle tube (134) of the suction nozzle (88) is pressed against a predetermined set part (190), with lowering of the suction nozzle (88) by the lifting and lowering device (156) at an interval between mounting works by the suction nozzle (88),
**characterized in that**
the suction nozzle (88) comprises a second coil spring (122) that biases the body cylinder (130) downwards,
the confirmation device (36) is configured to stop lowering the suction nozzle (88) at a timing T1 when a peak in the torque value of the electromagnetic motor (158) indicates that a tip end of the nozzle tube (134) comes into contact with the predetermined set part (190), and to confirm the slidability of the nozzle tube (134) based on the torque value of the electromagnetic motor (158) when a set period of time on the order of msec has elapsed from the timing T1, and
the torque value of the electromagnetic motor (158) necessary to compress the second coil spring (122) a certain distance is distinctly greater than the torque value of the electromagnetic motor (158) necessary to compress the first coil spring (114) said certain distance.

2. The mounting work machine (10) according to claim 1, further comprising:
an imaging device (26) capable of imaging the tip end of the nozzle tube (134) of the suction nozzle (88),
wherein the confirmation device (36) is configured to confirm the slidability of the nozzle tube (134) based on captured image data of a tip end position of the nozzle tube (134) before being pressed against the set part (190) and captured image data of a tip end position of the nozzle tube (134) after being pressed against the set part (190).

3. The mounting work machine (10) according to any one of claim 1 or claim 2,
wherein the lifting and lowering device (156) is capable of lifting and lowering each of multiple suction nozzles (88), and
wherein the confirmation device (36) is configured to confirm the slidability of the nozzle tube (134) of each of the multiple suction nozzles (88) with lowering of each of the multiple suction nozzles (88) by the lifting and lowering device (156).

4. A confirmation method in a mounting work machine (10) including a suction nozzle (88) wherein a nozzle tube (134) is slidably held by a body cylinder (130), the suction nozzle (88) being configured to extend and contract with sliding of a nozzle tube (134), a first coil spring (114) biasing the nozzle tube (134) downwards, a second coil spring (122) biasing the body cylinder (130) downwards, wherein the torque value of the electromagnetic motor (158) necessary to compress the second coil spring (122) a certain distance is distinctly greater than the torque value of the electromagnetic motor (158) necessary to compress the first coil spring (114) said certain distance, and a lifting and lowering device (156) configured to lift and lower the suction nozzle (88) by an operation of an electromagnetic motor (158), the method comprising:
confirming slidability of the nozzle tube (134) relative to the body cylinder (130) by monitoring a torque value of the electromagnetic motor (158) when a tip end of the nozzle tube (134) of the suction nozzle (88) is pressed against a predetermined set part (190), with lowering of the suction nozzle (88) by the lifting and lowering device (156) at an interval between mounting works by the suction nozzle (88),
**characterized by**
determining a timing T1 when a peak in the torque value of the electromagnetic motor (158) indicates that a tip end of the nozzle tube (134) comes into contact with the predetermined set part (190),
stop lowering the suction nozzle (88) at the timing T1,
confirming the slidability of the nozzle tube (134) based on the torque value of the electromagnetic motor (158) when a set period of time on the order of msec has elapsed from the timing T1.

## Patentansprüche

1. Montageoperationsmaschine (10), umfassend:
eine Saugdüse (88), in der ein Düsenrohr (134) verschiebbar von einem Körperzylinder (130) gehalten wird, wobei die Saugdüse (88) so ausgebildet ist, dass sie sich durch das Verschieben des Düsenrohrs (134) verlängert und verkürzt, und wobei eine erste Schraubenfeder (114) das Düsenrohr (134) nach unten vorspannt;
eine Hebe- und Senkvorrichtung (156), die so ausgebildet ist, dass sie die Saugdüse (88) durch den Betrieb eines Elektromotors (158) anhebt und absenkt; und
eine Bestätigungsvorrichtung (36), die so ausgebildet ist, dass sie die Gleitfähigkeit des Düsenrohrs (134) relativ zum Körperzylinder (130) bestätigt, indem sie einen Drehmomentwert des Elektromotors (158) überwacht, wenn ein vorderes Ende des Düsenrohrs (134) der Saugdüse (88) gegen ein vorbestimmtes Einstellteil (190) gedrückt wird, wobei die Saugdüse (88) durch die Hebe- und Senkvorrichtung (156) in einem Intervall zwischen den Montagearbeiten der Saugdüse (88) abgesenkt wird,
**dadurch gekennzeichnet, dass**
die Saugdüse eine zweite Schraubenfeder (122) umfasst, die den Körperzylinder (130) nach unten vorspannt,
die Bestätigungsvorrichtung (36) so ausgebildet ist, dass sie das Absenken der Saugdüse (88) zu einem Zeitpunkt T1 stoppt, wenn ein Spitzenwert des Drehmoments des Elektromotors (158) anzeigt, dass ein vorderes Ende des Düsenrohrs (134) mit dem vorbestimmten Einstellteil (190) in Kontakt kommt, und dass sie die Gleitfähigkeit des Düsenrohrs (134) auf der Grundlage des Drehmomentwerts des Elektromotors (158) bestätigt, nachdem seit dem Zeitpunkt T1 eine festgelegte Zeitspanne in der Größenordnung von Millisekunden verstrichen ist, und
der Drehmomentwert des Elektromotors (158), der erforderlich ist, um die zweite Schraubenfeder (122) um einen bestimmten Abstand zusammenzudrücken, deutlich größer ist als der Drehmomentwert des Elektromotors (158), der erforderlich ist, um die erste Schraubenfeder (114) um den genannten bestimmten Abstand zusammenzudrücken.

2. Montageoperationsmaschine (10) nach Anspruch 1, ferner umfassend:
eine Bildaufnahmevorrichtung (26), die in der Lage ist, das vordere Ende des Düsenrohrs (134) der Saugdüse (88) abzubilden,
wobei die Bestätigungsvorrichtung (36) so konfiguriert ist, dass sie die Gleitfähigkeit des Düsenrohrs (134) auf der Grundlage von erfassten Bilddaten einer Position des vorderen Endes des Düsenrohrs (134) vor dem Drücken gegen das Einstellteil (190) und von erfassten Bilddaten einer Position des vordere Endes des Düsenrohrs (134) nach dem Drücken gegen das Einstellteil (190) bestätigt.

3. Montageoperationsmaschine (10) nach einem der Ansprüche 1 oder 2,
wobei die Hebe- und Senkvorrichtung (156) in der Lage ist, jede von mehreren Saugdüsen (88) anzuheben und abzusenken, und
wobei die Bestätigungsvorrichtung (36) so ausgebildet, um die Gleitfähigkeit des Düsenrohrs (134) jeder der mehreren Saugdüsen (88) durch Absenken jeder der mehreren Saugdüsen (88) durch die Hebe- und Senkvorrichtung (156) zu bestätigen.

4. Bestätigungsverfahren in einer Montageoperationsmaschine (10) mit eine Saugdüse (88), in der ein Düsenrohr (134) verschiebbar von einem Körperzylinder (130) gehalten wird, wobei die Saugdüse (88) so ausgebildet ist, dass sie sich durch das Verschieben des Düsenrohrs (134) verlängert und verkürzt, und wobei eine erste Schraubenfeder (114) das Düsenrohr (134) nach unten vorspannt, eine zweite Schraubenfeder (122), die den Körperzylinder (130) nach unten vorspannt, wobei der Drehmomentwert des Elektromotors (158), der erforderlich ist, um die zweite Schraubenfeder (122) um einen bestimmten Abstand zusammenzudrücken, deutlich größer ist als der Drehmomentwert des Elektromotors (158), der erforderlich ist, um die erste Schraubenfeder (114) um den genannten bestimmten Abstand zusammenzudrücken, und eine Hebe- und Senkvorrichtung (156), die so ausgebildet ist, dass sie die Saugdüse (88) durch den Betrieb eines Elektromotors (158) anhebt und absenkt, wobei das Verfahren umfasst:
Bestätigen der Gleitfähigkeit des Düsenrohrs (134) relativ zum Körperzylinder (130) durch Überwachen eines Drehmomentwerts des Elektromotors (158), wenn ein vorderes Ende des Düsenrohrs (134) der Saugdüse (88) gegen ein vorbestimmtes Einstellteil (190) gedrückt wird, wobei die Saugdüse (88) durch die Hebe- und Senkvorrichtung (156) in einem Intervall zwischen den Montagearbeiten der Saugdüse (88) abgesenkt wird, **gekennzeichnet durch**
Ermitteln eines Zeitpunkts T1, zu dem ein Spitzenwert des Drehmoments des Elektromotors (158) anzeigt, dass ein vorderes Ende des Düsenrohrs (134) mit dem vorbestimmten Einstellteil (190) in Kontakt kommt,
Anhalten des Absenkens der Saugdüse (88) zum Zeitpunkt T1,
Bestätigen der Gleitfähigkeit des Düsenrohrs (134) auf der Grundlage des Drehmomentwerts des Elektromotors (158), wenn seit dem Zeitpunkt T1 eine festgelegte Zeitspanne in der Größenordnung von Millisekunden verstrichen ist.

## Revendications

1. Machine pour tâches de montage (10), comprenant :
une buse d'aspiration (88) dans laquelle un tube de buse (134) est maintenu de manière coulissante par un cylindre de corps (130), la buse d'aspiration (88) étant configurée pour se déployer et se rétracter avec le glissement du tube de buse (134), un premier ressort hélicoïdal (114) rappelant le tube de buse (134) vers le bas ;
un dispositif de levage et d'abaissement (156) configuré pour lever et abaisser la buse d'aspiration (88) par l'actionnement d'un moteur électromagnétique (158) ; et
un dispositif de confirmation (36) configuré pour confirmer la capacité de coulissement du tube de buse (134) par rapport au cylindre de corps (130) en surveillant une valeur de couple du moteur électromagnétique (158) quand une extrémité du tube de buse (134) de la buse d'aspiration (88) est pressée contre une pièce de réglage prédéterminée (190), lors de l'abaissement de la buse d'aspiration (88) par le dispositif de levage et d'abaissement (156) pendant un intervalle entre les tâches de montage par la buse d'aspiration (88),
**caractérisée en ce que**
la buse d'aspiration (88) comprend un deuxième ressort hélicoïdal (122) qui rappelle le cylindre de corps (130) vers le bas,
le dispositif de confirmation (36) est configuré pour arrêter l'abaissement de la buse d'aspiration (88) à un instant T1 quand un pic de la valeur de couple du moteur électromagnétique (158) indique qu'une extrémité du tube de buse (134) entre en contact avec la pièce de réglage prédéterminée (190), et pour confirmer la capacité de coulissement du tube de buse (134) sur la base de la valeur de couple du moteur électromagnétique (158) quand une période définie de l'ordre de la milliseconde s'est écoulée depuis l'instant T1, et
la valeur de couple du moteur électromagnétique (158) nécessaire pour comprimer le deuxième ressort hélicoïdal (122) d'une certaine distance est nettement supérieure à la valeur de couple du moteur électromagnétique (158) nécessaire pour comprimer le premier ressort hélicoïdal (114) de ladite certaine distance.

2. Machine pour tâches de montage (10) selon la revendication 1, comprenant en outre :
un dispositif d'imagerie (26) capable d'imager l'extrémité du tube de buse (134) de la buse d'aspiration (88),
dans laquelle le dispositif de confirmation (36) est configuré pour confirmer la capacité de coulissement du tube de buse (134), sur la base des données d'image capturées de la position de l'extrémité du tube de buse (134) avant qu'elle soit pressée contre la pièce de réglage (190) et des données d'image capturées de la position de l'extrémité du tube de buse (134) après qu'elle est pressée contre la pièce de réglage (190).

3. Machine pour tâches de montage (10) selon l'une quelconque des revendications 1 et 2,
dans laquelle le dispositif de levage et d'abaissement (156) est capable de lever et d'abaisser chaque buse parmi de multiples buses d'aspiration (88), et
dans laquelle le dispositif de confirmation (36) est configuré pour confirmer la capacité de coulissement du tube de buse (134) de chaque buse parmi lesdites multiples buses d'aspiration (88) lors de l'abaissement de chaque buse parmi lesdites multiples buses d'aspiration (88) par le dispositif de levage et d'abaissement (156).

4. Procédé de confirmation dans une machine pour tâches de montage (10) incluant une buse d'aspiration (88) dans laquelle un tube de buse (134) est maintenu de manière coulissante par un cylindre de corps (130), la buse d'aspiration (88) étant configurée pour se déployer et se rétracter par coulissement d'un tube de buse (134), un premier ressort hélicoïdal (114) rappelant le tube de buse (134) vers le bas, un deuxième ressort hélicoïdal (122) rappelant le cylindre de corps (130) vers le bas, dans lequel la valeur de couple du moteur électromagnétique (158) nécessaire pour comprimer le deuxième ressort hélicoïdal (122) d'une certaine distance est nettement supérieure à la valeur de couple du moteur électromagnétique (158) nécessaire pour comprimer le premier ressort hélicoïdal (114) de ladite certaine distance, et un dispositif de levage et d'abaissement (156) configuré pour lever et abaisser la buse d'aspiration (88) par un actionnement d'un moteur électromagnétique (158), le procédé comprenant :
la confirmation de la capacité de coulissement du tube de buse (134) par rapport au cylindre de corps (130) en surveillant une valeur de couple du moteur électromagnétique (158) quand une extrémité du tube de buse (134) de la buse d'aspiration (88) est pressée contre une pièce de réglage prédéterminée (190), lors de l'abaissement de la buse d'aspiration (88) par le dispositif de levage et d'abaissement (156) pendant un intervalle entre les tâches de montage par la buse d'aspiration (88),
**caractérisé par**
la détermination d'un instant T1 où un pic de la valeur de couple du moteur électromagnétique (158) indique que l'extrémité du tube de buse (134) entre en contact avec la pièce de réglage prédéterminée (190),
l'arrêt de l'abaissement de la buse d'aspiration (88) à l'instant T1,
la confirmation de la capacité de coulissement du tube de buse (134) sur la base de la valeur de couple du moteur électromagnétique (158) quand une période définie de l'ordre de la milliseconde s'est écoulée depuis l'instant T1.
